# EUROPÄISCHE PATENTSCHRIFT

(11) **EP 3 664 128 B1**
(45) Veröffentlichungstag und Bekanntmachung des Hinweises auf die Patenterteilung: **31.03.2021**
(21) Anmeldenummer: 18210737.5
(22) Anmeldetag: 06.12.2018
(51) Int. Cl.: H01L 21/673, B65D 85/30

(54) **VERPACKUNGSEINHEIT FÜR SUBSTRATE**
PACKAGING UNIT FOR SUBSTRATES
UNITÉ D'EMBALLAGE POUR SUBSTRATS

(43) Veröffentlichungstag der Anmeldung: 10.06.2020
(73) Patentinhaber: Heraeus Deutschland GmbH & Co. KG, 63450 Hanau (DE)
(72) Erfinder: RICHTER, Hans-Jürgen, 63450 Hanau (DE); WACKER, Richard, 63450 Hanau (DE); Pelshaw, Nadja, 63450 Hanau (DE); LÖWER, Yvonne, 63450 Hanau (DE)
(74) Vertreter: Maiwald Patent- und Rechtsanwaltsgesellschaft mbH

(56) Entgegenhaltungen:
- WO-A1-2007/007941
- WO-A1-2017/139490
- WO-A2-2007/092557
- CN-B- 106 742 537
- DE-A1-102004 056 879
- DE-B4-102010 018 668
- DE-B4-102012 106 087
- JP-A- 2005 132 438
- JP-A- 2011 148 510

## Beschreibung

### Technisches Gebiet

Die vorliegende Erfindung betrifft eine Verpackungseinheit für Substrate, einen Verpackungsstapel mit solchen Verpackungseinheiten und ein Verfahren zur Verpackung von Substraten.

### Hintergrund der Erfindung

Keramikschaltungsträger sind aufgrund ihrer hohen Wärmeleitfähigkeit, hohen Formstabilität bzw. mechanischen Festigkeit sowie ihrer hohen Isolationsfestigkeit insbesondere im Bereich der Hochleistungselektronik von Interesse.

DE 10 2010 018 668 B4 offenbart eine Verpackungseinheit aus einer Verpackung für Metall-Keramik-Substrate und mehreren Metall-Keramik-Substraten, jeweils bestehend aus einer Keramikschicht und aus auf wenigstens einer Oberflächenseite der Keramikschicht gebildeten Einzelmetallisierung und zwischen diesen verlaufenden Sollbruchlinien.

DE 10 2012 106 087 B4 offenbart eine Verpackungseinheit für Substrate, insbesondere für Metall-Keramik-Substrate, bestehend aus einer Verpackung mit einem aus einem Flachmaterial hergestellten Verpackungsunterteil und einer von einer Vertiefung in einem oberen Bodenabschnitt des Verpackungsunterteils gebildeten Aufnahme für mehrere oder wenigstens einen Substratstapel oder Teilstapel.

Das Dokument JP 2011 148510-A offenbart eine Verpackungseinheit für Substrate, wobei die Substrate nebeneinander angeordnet sein können. Die Verpackung ist so ausgelegt, dass mehrere Verpackungseinheiten übereinander gestapelt werden können.

Besonders für empfindliche Substrate und insbesondere Substrate mit empfindlichen Oberflächen oder Oberflächenabschnitten können diese Verpackungen aber noch verbessert werden.

### Zusammenfassung der Erfindung

Es ist daher eine Aufgabe der vorliegenden Erfindung, eine Verpackungseinheit für Substrate bereitzustellen, mit welcher auch empfindliche Substrate sicher verpackt werden können.

Diese Aufgabe wird durch eine Verpackungseinheit für Substrate, einen Verpackungsstapel mit einer Vielzahl solcher Verpackungseinheiten und ein Verfahren zur Verpackung von Substraten nach den unabhängigen Ansprüchen gelöst. Vorteilhafte Ausführungsformen und Weiterbildungen sind den Unteransprüchen und der nachfolgenden Beschreibung zu entnehmen.

Die Verpackungseinheit für Substrate umfasst ein erstes Substrat, einen Abstandshalter und ein zweites Substrat. Der Abstandshalter ist auf das erste Substrat aufgelegt und das zweite Substrat ist auf den Abstandshalter aufgelegt. Ein Metalldepot ist jeweils auf eine Oberfläche des ersten Substrats und auf eine Oberfläche des zweiten Substrats aufgebracht und auf den beiden Metalldepots ist je ein Klebepunkt angeordnet. Der Abstandshalter ist so auf das erste Substrat aufgelegt, dass der Abstandshalter das erste Substrat nur außerhalb des Klebepunkts berührt.

Das Substrat kann ein beliebiges Trägermaterial sein, welches zum Beispiel nicht sofort fertig verarbeitet wird und daher zunächst zuverlässig aufbewahrt werden muss. Das Substrat kann flächenförmig ausgebildet sein und eine flache ebene Struktur aufweisen. Beispielsweise kann das Substrat in der Halbleitertechnik ein Ausgangsmaterial für eine Fertigung von Elektronikmodulen sein.

Das Substrat weist auf seiner Oberfläche ein sogenanntes Metalldepot auf. Das Metalldepot, in anderen Worten ein Metallvorrat, kann je nach Einsatzzweck ein Metall oder mehrere verschiedene Metalle in bestimmten Mischungsverhältnissen umfassen oder daraus bestehen. Das Metalldepot kann beispielsweise für eine dauerhafte, feste Verbindung von Bauteilen geeignet sein, beispielsweise indem es sich als Schmelze mit der Oberfläche von Bauteilen verbindet bzw. legiert und nach Abkühlung erstarrt oder indem es sich im Sinne eines Sintermaterials ohne zu schmelzen mit der Oberfläche von Bauteilen verbindet. Größe und Dicke des Metalldepots können auch je nach Einsatzzweck variiert werden.

Auf dem Metalldepot ist ein Klebepunkt angeordnet. Der Klebepunkt kann dazu dienen, ein zum Beispiel elektronisches Bauteil auf dem Substrat zu fixieren, um einen darauffolgenden Löt- oder Sintervorgang zwischen dem elektronischen Bauteil und dem Substrat zu erleichtern. Der Klebepunkt kann beim Verlöten oder beim Sintern des elektronischen Bauteils mit dem Substrat unzersetzt verdampfen und/oder sich unter Zersetzung verflüchtigen, sodass der Klebepunkt keine oder keine störenden Rückstände hinterlässt.

Die Verpackungseinheit weist einen Abstandshalter auf, welcher zwischen zwei aufeinanderfolgenden Substraten positioniert werden kann, um einen Kontakt zwischen den Substraten zu vermeiden. Der Abstandshalter ist so auf das erste Substrat aufgelegt, dass der Abstandshalter das erste Substrat nur außerhalb des Klebepunkts berührt. In anderen Worten, der Abstandshalter berührt den Klebepunkt nicht, weder seitlich noch an der Oberseite des Klebepunkts. Der Abstandshalter kann so auf das erste Substrat aufgelegt sein, dass er das erste Substrat auch nur außerhalb des Metalldepots berührt. Bevorzugt berührt der Abstandshalter das Metalldepot weder seitlich noch an der Oberseite des Metalldepots.

Das erste und zweite Substrat können in vertikaler Richtung aufeinandergestapelt werden. Dabei ist es wichtig, dass der Klebepunkt nicht berührt bzw. verschmiert wird. Der Abstandshalter kann daher nur außerhalb des Klebepunkts das Substrat berühren. In anderen Worten, der Abstandshalter kann zumindest einen Ausschnitt aufweisen, sodass der Abstandshalter auf die Oberfläche des ersten Substrats aufgelegt werden kann, ohne den Klebepunkt zu berühren. Auf den Abstandshalter kann das zweite Substrat aufgelegt werden, wobei der Abstandshalter eine Unterseite des zweiten Substrats berührt. Die "Unterseite" kann eine Oberfläche des Substrats sein, auf welcher weder Metalldepot noch Klebepunkt platziert wird. Im Gegensatz dazu kann eine "Oberseite" eine Oberfläche des Substrats sein, auf welcher das Metalldepot und der Klebepunkt appliziert sind.

Der Abstandshalter kann kleiner als oder gleich groß wie das Substrat sein. In anderen Worten, die äußeren Abmessungen des Abstandshalters können maximal so groß wie die äußeren Abmessungen des Substrats sein. Noch präziser, ein Außenumfang oder eine Außenkontur des Abstandshalters kann kleiner als oder genauso groß sein wie ein Außenumfang oder eine Außenkontur des Substrats.

Der Vorteil der erfindungsgemäßen Verpackungseinheit liegt darin, dass auch empfindliche Substrate sicher verpackt und insbesondere platzsparend gestapelt werden können, ohne den Klebepunkt auf dem Metalldepot zu berühren. Die erfindungsgemäße Verpackungseinheit ermöglicht, dass das Metalldepot und der Klebepunkt unmittelbar nach dem Herstellen des Substrates durch einen Hersteller oder Weiterverarbeiter des Substrats auf das Substrat aufgebracht werden können und das Substrat mit Metalldepot und Klebepunkt problemlos an einen Weiterverarbeiter oder einen Anwender verschickt werden kann. Auf diese Weise können Weiterverarbeiter oder Anwender des mit Metalldepot und Klebepunkt versehenen Substrats ein weiteres Bauteil direkt auf den Klebepunkt des Substrates aufbringen und beispielsweise mittels eines Löt- oder Sinterverfahrens das Bauteil direkt (ohne eine Vorarbeit zum Fixieren des Bauteils) befestigen. Dieses sogenannte Vorapplizieren des Metalldepots und des Klebepunkts ermöglicht, dass ein weiteres Bauteil kostengünstig auf dem Substrat befestigt werden kann. Bislang werden die Substrate generell ohne vorapplizierte Metall- oder Lotdepots hergestellt und vertrieben. Daher ist es nicht erforderlich, die Substrate anders als durch durchgängige Folien voneinander zu separieren. Im Falle eines Substrats mit vorappliziertem Metalldepot jedoch wird ein Klebepunkt auf das Substrat aufgebracht, der während des Verpackens und Versands der Teile nicht verschmiert oder berührt werden darf. Der Abstandshalter bzw. der Ausschnitt des Abstandshalters kann dazu beitragen, dass die Substrate gestapelt, aufbewahrt und/oder transportiert werden können, ohne den Klebepunkt zu berühren.

Das erste Metalldepot und der erste Klebepunkt auf dem ersten Substrat und das zweite Metalldepot und der zweite Klebepunkt auf dem zweiten Substrat können in vertikaler Richtung, also senkrecht zur Flächenausdehnung der Substrate, in die gleiche Richtung weisen. Sie können also entweder alle auf den Oberseiten der beiden Substrate oder alle auf den Unterseiten der beiden Substrate angeordnet sein. Es ist natürlich auch möglich, dass ein Klebepunkt auf der Oberseite des einen Substrats angeordnet ist und ein Klebepunkt auf der Unterseite des anderen Substrats angeordnet ist, sodass die Klebepunkte in unterschiedliche Richtungen weisen, d.h. entweder aufeinander zu streben oder voneinander wegweisen.

Das erste und/oder das zweite Substrat können aber auch auf beiden Seiten jeweils ein Metalldepot und auch einen Klebepunkt umfassen. Das bedeutet, dass zumindest eines der Substrate sowohl auf seiner Oberseite als auch auf seiner Unterseite ein Metalldepot und auch einen Klebepunkt aufweisen kann. Der Ausschnitt des Abstandshalters kann so eingerichtet sein, dass der in vertikaler Richtung nach oben gerichtete Klebepunkt des ersten Substrats und der in vertikaler Richtung nach unten gerichtete Klebepunkt des zweiten Substrats nicht miteinander in Berührung kommen.

In einer Ausführungsform ist das erste Substrat ein erstes Metallkeramiksubstrat und das zweite Substrat ein zweites Metallkeramiksubstrat.

In einer Ausführungsform umfassen das erste und das zweite Metallkeramiksubstrat jeweils eine Keramikschicht und mindestens eine Metallisierungsschicht, wobei das Metalldepot auf die Metallisierungsschicht aufgebracht ist. In einer Ausführungsform umfasst das Metallkeramiksubstrat die Keramikschicht und zwei Metallisierungsschichten, wobei das Metalldepot auf eine der Metallisierungsschichten aufgebracht ist. In einer Ausführungsform umfasst das Metallkeramiksubstrat eine Keramikschicht und zwei Metallisierungsschichten und beide Metallisierungsschichten weisen eine außenliegende Oberfläche auf, auf die ein Metalldepot aufgebracht ist.

Der Begriff "Metallkeramiksubstrat" kann so verstanden werden, dass das Substrat aus Keramik hergestellt und durch verschiedene Verfahren wie z.B. Direct-Copper-Bonding (üblicherweise als DCB-Verfahren bezeichnet), Direct-Aluminium-Bonding (üblicherweise als DAB-Verfahren bezeichnet) oder Active-Metal-Brazing (üblicherweise als AMB-Verfahren bezeichnet) metallisiert werden kann. Geeignete Materialien für das Keramiksubstrat sind beispielsweise ein Oxid, ein Nitrid, ein Carbid, oder ein Gemisch oder Komposit aus zumindest zweien dieser Materialien, insbesondere ggf. dotierte Aluminiumoxid- oder Siliziumnitrid-Keramik. Das nach der Metallisierung des Keramiksubstrats erhaltene Verbundmaterial wird auch als Metall-Keramik-Substrat oder Metall-Keramik-Verbund bezeichnet. Sofern es beispielsweise durch ein DCB-Verfahren hergestellt wurde, wird häufig auch die Bezeichnung "DCB-Substrat" verwendet.

Eine Metallisierung des Keramiksubstrats kann beispielsweise dadurch realisiert werden, dass zunächst eine Metallfolie oxidiert wird, sodass sich an deren Oberfläche eine Metalloxidschicht bildet. Die oxidierte Metallfolie wird auf das Keramiksubstrat aufgelegt und das Keramiksubstrat mit der oxidierten Metallfolie erhitzt. Das Metallkeramiksubstrat kann eine feste Bindung der Metallbeschichtung an der Keramikoberfläche aufweisen, wobei diese Bindung auch unter längeren Temperaturwechselbelastungen ausreichend festbleiben soll.

Das Metalldepot kann im Falle eines lötbaren Metalls durch Löten, beispielsweise durch ein Vakuumlöten in einer aktiven Atmosphäre mit Ameisensäureaktivierung, auf das Metallkeramiksubstrat aufgebracht werden. Im Falle eines sinterbaren Metalls kann das Metalldepot durch Sintern oder Ansintern auf das Metallkeramiksubstrat aufgebracht werden.

Das Metalldepot kann auf dem Metallkeramiksubstrat in einem definierten Volumen, an einer definierten Position und mit einer definierten Form appliziert werden. Auf diese Weise kann das Metallkeramiksubstrat ohne einen Metallpastendruck und/oder einen Reinigungsvorgang weiterverarbeitet werden. Dies ermöglicht, dass ein weiteres Bauteil wie z.B. ein Chip auf das Substrat bzw. Metalldepot vereinfacht aufgebracht und dort beispielsweise ohne Verwendung von Hilfsstoffen wie beispielsweise Flussmitteln, Reinigungsmitteln und ähnlichem befestigt werden kann.

In einer Ausführungsform umfasst das Metalldepot ein lötbares oder sinterbares Metall oder eine lötbare oder sinterbare Legierung. Das Metalldepot kann auch als ein Lot- oder Sinterdepot verstanden werden und ein bestimmtes Volumen aufweisen oder eine Metall-/Legierungsschicht sein. Das Metalldepot kann ein lötbares oder sinterbares Metall oder eine lötbare oder sinterbare Legierung sein.

In der vorliegenden Erfindung ist der Abstandshalter stegförmig. In anderen Worten, der Abstandshalter kann zumindest einen Ausschnitt, bevorzugt eine Vielzahl von Ausschnitten und Zwischenbrücken bzw. Führungsleisten aufweisen, die die Ausschnitte verbinden. Die Ausschnitte können eine identische Form aufweisen und die Form kann rechteckig, rund, oval oder ähnlich ausgebildet sein. Jeder der Ausschnitte kann auch unterschiedliche Formen aufweisen. Die Ausschnitte können dazu dienen, dass der Klebepunkt auf dem Metalldepot trotz des Stapelns von Substraten und Abstandshaltern unberührt bleibt und somit nicht verschmiert wird.

In einer Ausführungsform weist der Abstandshalter eine Dicke zwischen 200 und 1000 µm, bevorzugt zwischen 300 und 800 µm auf. Die Dicke des Abstandshalters kann so ausgelegt sein, dass sie zumindest der Höhe des Metalldepots zusammen mit der Höhe des Klebepunkts entspricht. Die Dicke des Abstandshalters kann auch so ausgelegt sein, dass sie zusätzlich einen Sicherheitsabstand umfasst. Der Sicherheitsabstand kann zum Beispiel 50 bis 100 µm betragen. Mit oder ohne Sicherheitsabstand kann der Klebepunkt auf dem Metalldepot trotz des Stapelns von Substraten und Abstandshaltern unberührt bleiben und somit nicht verschmiert werden. In einer anderen Ausführungsform, wenn die Metalldepots und die Klebepunkte so auf der Unterseite des einen Substrats und der Oberseite des anderen Substrats angeordnet sind, dass sie aufeinander zuweisen, kann die Dicke des Abstandshalters so ausgelegt werden, dass sie zumindest der Höhe der beiden Metalldepots zusammen mit der Höhe der beiden Klebepunkte mit oder ohne einen Sicherheitsabstand entspricht.

In einer Ausführungsform ist der Abstandshalter aus Kunststoff oder Karton hergestellt. Der Abstandshalter kann aus Rollenware hergestellt werden. Auf diese Weise kann der Abstandshalter kostengünstig und einfach hergestellt werden.

In einer Ausführungsform umfasst die Verpackungseinheit einen weiteren Abstandshalter, der auf das zweite Substrat aufgelegt ist. Auf diese Weise kann ein drittes Substrat auf den weiteren Abstandshalter aufgelegt werden. Der weitere Abstandshalter kann aber auch einen Abschluss der Verpackungseinheit bilden. Selbstverständlich kann die Verpackungseinheit eine Vielzahl von abwechselnd angeordneten Substraten und Abstandshaltern umfassen.

In einer Ausführungsform sind die Abstandshalter baugleich. Die Abstandshalter können aber auch beispielsweise je nach Größe und Position des Metalldepots und des Klebepunkts auf dem jeweiligen Substrat unterschiedlich ausgelegt sein.

In einer Ausführungsform sind die Klebepunkte bei Raumtemperatur verschmierbar. Verschmierbar bedeutet, dass die Klebepunkte nach dem Applizieren auf den Metalldepots beispielsweise angetrocknet sein können, jedoch an der Luft nicht fest oder hart werden, sondern klebrig oder schmierig bleiben. Die verschmierbaren Klebepunkte sind weder vollständig fest noch vollständig flüssig. Sie können eine bestimmte Viskosität aufweisen, sodass sich beispielsweise ein auf den Klebepunkt aufgebrachtes weiteres Bauteil selbst bei einer zum Beispiel 90° schrägen Lage des Substrats nicht selbstständig bewegt oder selbstständig rutschen kann.

In einer Ausführungsform sind die beiden Klebepunkte gestaltet, um jeweils ein elektronisches Bauteil auf dem ersten Substrat und auf dem zweiten Substrat zu fixieren. Das Metallkeramiksubstrat kann für eine elektronische Anwendung geeignet sein, bei der ein elektronisches Bauteil beispielsweise ein Chip, ein Schalter, ein Beleuchtungselement, ein Kondensator, ein Widerstand oder ähnliches aufgebracht wird.

In einer Ausführungsform ist das erste Substrat und/oder das zweite Substrat ein Direct Copper Bonding (DCB) oder ein Direct Aluminium Bonding (DAB) Substrat. Das DCB- bzw. DAB-Substrat kann eine gute elektrische und thermische Verbindung elektronischer Bauteile und Chips über Kupfer bzw. Aluminium ermöglichen.

In der vorliegenden Erfindung umfasst zumindest das erste Substrat eine Vielzahl von nebeneinander angeordneten Einzelsubstraten und der Abstandshalter umrandet die Einzelsubstrate. Das Substrat kann in Form eines Einzelsubstrats vorliegen. Alternativ ist es auch möglich, dass das Substrat eine oder mehrere (bevorzugt geradlinig verlaufende) Sollbruchlinien aufweist, die das Substrat in zwei oder mehr Bereiche unterteilen. Der Abstandshalter kann zeilenförmig bzw. rasterförmig zwischen den Einzelsubstraten verlaufen. Die vorliegende Erfindung umfasst weiterhin einen Verpackungsstapel, welcher eine Vielzahl von aufeinandergestapelten Verpackungseinheiten umfasst. Durch eine relativ flache Konfiguration des Substrats und des Abstandshalters kann es möglich sein, dass eine Vielzahl von Substraten und Abstandshaltern platzsparend aufeinandergestapelt werden können. Die rasterförmigen Abstandshalter können ermöglichen, dass die Klebepunkte auf den Metalldepots trotz des Stapelns von mehreren Substraten und Abstandshaltern berührungsfrei bleiben. Der Verpackungsstapel kann je nach Einsatzzweck und Lagerkapazität eine beliebige Anzahl von Verpackungseinheiten und damit eine beliebige Anzahl von Substraten und Abstandshaltern aufweisen.

Die vorliegende Erfindung umfasst weiterhin ein Verfahren zur Verpackung von Substraten. Das Verfahren umfasst die folgenden Schritte:
- Bereitstellen eines ersten Substrats,
- Auflegen eines Abstandshalters auf das erste Substrat, und
- Auflegen eines zweiten Substrats auf den Abstandshalter.

Jeweils auf eine Oberfläche des ersten Substrats und auf eine Oberfläche des zweiten Substrats ist ein Metalldepot aufgebracht und auf den beiden Metalldepots ist je ein Klebepunkt angeordnet. Des Weiteren ist der Abstandshalter so auf das erste Substrat aufgelegt, dass der Abstandshalter das erste Substrat nur außerhalb des Klebepunkts berührt.

Weitere Merkmale, Vorteile und Anwendungsmöglichkeiten der vorliegenden Erfindung ergeben sich aus der nachfolgenden Beschreibung, den Ausführungsbeispielen und den Figuren. Alle beschriebenen und/oder bildlich dargestellten Merkmale können unabhängig von ihrer Darstellung in einzelnen Ansprüchen, Figuren, Sätzen oder Absätzen miteinander kombiniert werden. In den Figuren stehen gleiche Bezugszeichen für gleiche oder ähnliche Objekte.

### Kurze Beschreibung der Figuren

Figur 1 zeigt eine Verpackungseinheit gemäß einer Ausführungsform.
Figur 2 zeigt eine Verpackungseinheit gemäß einer Ausführungsform.
Figur 3 zeigt ein Metallkeramiksubstrat gemäß einer Ausführungsform.
Figur 4 zeigt einen Verpackungsstapel gemäß einer Ausführungsform.

### Detaillierte Beschreibung von Ausführungsbeispielen

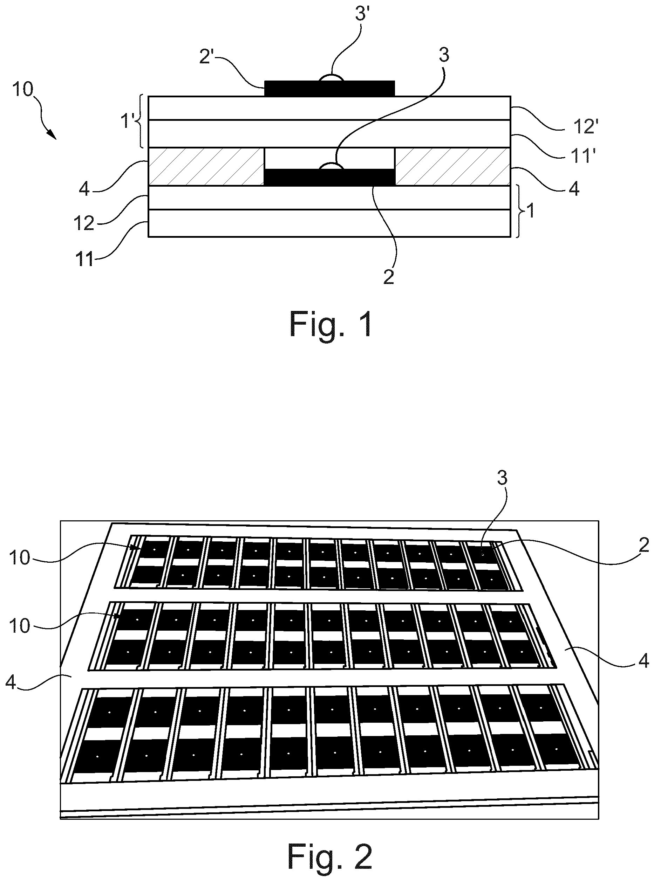

Figur 1 und Figur 2 zeigen eine Verpackungseinheit 10 für Metallkeramiksubstrate 1, 1'. Die Verpackungseinheit 10 umfasst ein erstes Substrat 1, einen Abstandshalter 4 und ein zweites Substrat 1'. Der Abstandshalter 4 ist auf das erste Substrat 1 aufgelegt, und das zweite Substrat 1' ist auf den Abstandshalter 4 aufgelegt.

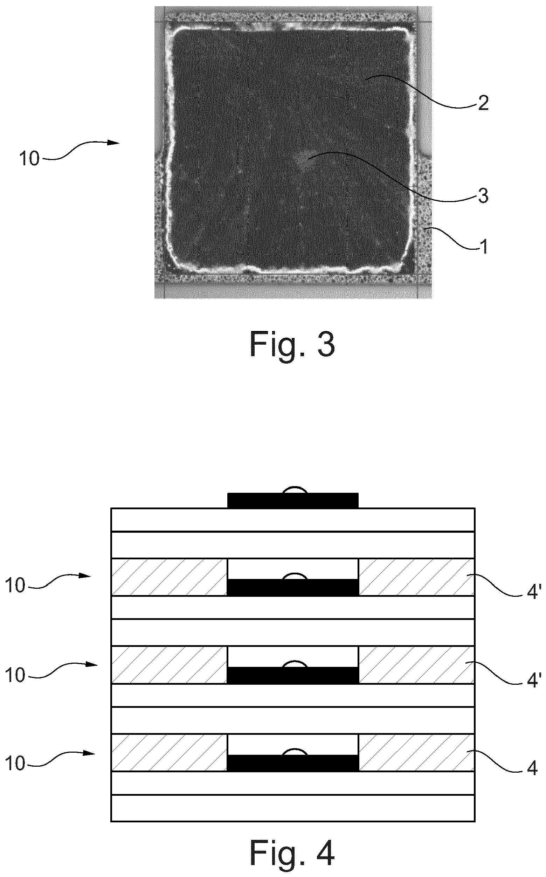

Das Metallkeramiksubstrat 1,1' kann durch ein Direct Copper Bonding (DCB) Verfahren oder Direct Aluminium Bonding (DAB) Verfahren hergestellt werden und eine Vielzahl von nebeneinander angeordneten Einzelsubstraten umfassen. Das Metallkeramiksubstrat 1, 1' weist eine Keramikschicht 11, 11' und mindestens eine Metallisierungsschicht 12, 12' auf. Das Metallkeramiksubstrat 1,1' weist vorzugsweise insgesamt zwei Metallisierungsschichten auf, nämlich die Metallisierungsschicht 12, 12' und eine nicht gezeigte weitere Metallisierungsschicht auf der anderen Seite der Keramikschicht 11, 11'. Wie auch in Figur 3 gezeigt, ist auf eine Oberseite der Metallisierungsschicht 12 der beiden Substrate 1,1' jeweils ein Metalldepot 2, 2' aufgebracht und auf den beiden Metalldepots 2, 2' ist je ein Klebepunkt 3, 3' angeordnet. Das Metalldepot 2, 2' umfasst ein lötbares oder sinterbares Metall oder eine lötbare oder sinterbare Legierung. Die Klebepunkte 3, 3' sind bei Raumtemperatur bzw. in Luft klebrig und verschmierbar. Die Klebepunkte 3, 3' weisen in die gleiche Richtung, hier nach oben, d.h. die zwei Klebepunkte 3, 3' sind beide auf den Oberseiten der jeweiligen Substrate 1,1' ausgebildet. Auf den jeweiligen Klebepunkten 3, 3' kann ein elektronisches Bauteil beispielsweise ein Chip, Leuchtmittel, Widerstand, Kondensator etc. aufgebracht werden.

Der Abstandshalter 4 ist stegförmig oder rasterförmig ausgebildet und so auf das erste Substrat 1 aufgelegt, dass der Abstandshalter 4 das erste Substrat 1 nur außerhalb des Klebepunkts 3 berührt. Der Abstandshalter 4 kann aus aufrollbarem Kunststoff oder Karton hergestellt werden. Eine Dicke bzw. Höhe des Abstandshalters 4 kann zwischen 200 und 1000 um, bevorzugt zwischen 300 und 800 µm betragen, sodass eine Untergrenze der Dicke des Abstandshalters 4 eine Summe von Metalldepot 2, Klebepunkt 3 und ggf. Sicherheitsabstand nicht unterschreitet. Die Obergrenze der Dicke des Abstandshalters 4 kann ferner so ausgelegt werden, dass ein Ausgangsmaterial für den Abstandshalter 4 aufgerollt werden kann. Wenn zumindest ein Substrat 1, 1' eine Vielzahl von nebeneinander angeordneten Einzelsubstraten umfasst, umrandet der Abstandshalter 4 die Einzelsubstrate, sodass die Klebepunkte 3 nicht berührt werden (siehe Figur 2).

Wie in Figur 4 gezeigt, kann die Verpackungseinheit 10 weiterhin einen weiteren Abstandshalter 4' aufweisen, der auf das zweite Substrat 1' aufgelegt wird. Auf diese Weise kann ein Verpackungsstapel realisiert werden, welcher eine Vielzahl von aufeinandergestapelten Verpackungseinheiten 10 umfasst.

Ergänzend sei darauf hingewiesen, dass "umfassend" und "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen. Der Schutzumfang der Anmeldung wird durch die Ansprüche festgelegt (Art. 69 EPÜ).

## Patentansprüche

1. Eine Verpackungseinheit (10) für Substrate (1, 1'), umfassend:
- ein erstes Substrat (1),
- einen Abstandshalter (4), und
- ein zweites Substrat (1'),
wobei der Abstandshalter (4) auf das erste Substrat (1) aufgelegt ist und das zweite Substrat (1') auf den Abstandshalter (4) aufgelegt ist,
wobei jeweils auf eine Oberfläche des ersten Substrats (1) und auf eine Oberfläche des zweiten Substrats (1') ein Metalldepot (2, 2') aufgebracht ist und auf den beiden Metalldepots (2, 2') je ein Klebepunkt (3, 3') angeordnet ist, und
wobei der Abstandshalter (4) so auf das erste Substrat (1) aufgelegt ist, dass der Abstandshalter (4) das erste Substrat (1) nur außerhalb des Klebepunkts (3) berührt, wobei der Abstandshalter (4) stegförmig ist, und
wobei zumindest das erste Substrat (1) eine Vielzahl von nebeneinander angeordneten Einzelsubstraten umfasst und der Abstandshalter (4) die Einzelsubstrate umrandet.

2. Verpackungseinheit (10) nach Anspruch 1, wobei das erste Substrat (1) ein erstes Metallkeramiksubstrat ist und das zweite Substrat (1') ein zweites Metallkeramiksubstrat ist.

3. Verpackungseinheit (10) dem vorherigen Anspruch, wobei das erste und das zweite Metallkeramiksubstrat (1, 1') jeweils eine Keramikschicht (11, 11') und mindestens eine Metallisierungsschicht (12, 12') umfassen und die Metallisierungsschicht (12, 12') die Oberfläche aufweist, auf die das Metalldepot (2, 2') aufgebracht ist.

4. Verpackungseinheit (10) nach einem der vorherigen Ansprüche, wobei das Metalldepot (2, 2') ein lötbares oder sinterbares Metall oder eine lötbare oder sinterbare Legierung umfasst.

5. Verpackungseinheit (10) nach einem der vorherigen Ansprüche, wobei der Abstandshalter (4) eine Dicke zwischen 200 und 1000 µm aufweist und vorzugsweise eine Dicke zwischen 300 und 800 µm aufweist.

6. Verpackungseinheit (10) nach einem der vorherigen Ansprüche, wobei der Abstandshalter (4) aus Kunststoff oder Karton hergestellt ist.

7. Verpackungseinheit (10) nach einem der vorherigen Ansprüche, weiterhin umfassend einen weiteren Abstandshalter (4'), der auf das zweite Substrat (1') aufgelegt ist.

8. Verpackungseinheit (10) nach dem vorherigen Anspruch, wobei die Abstandshalter (4) baugleich sind.

9. Verpackungseinheit (10) nach einem der vorherigen Ansprüche, wobei die Klebepunkte (3, 3') bei Raumtemperatur verschmierbar sind.

10. Verpackungseinheit (10) nach einem der vorherigen Ansprüche, wobei die Klebepunkte (3, 3') gestaltet sind, um jeweils ein elektronisches Bauteil auf dem ersten Substrat (1) und auf dem zweiten Substrat (1') zu fixieren.

11. Verpackungseinheit (10) nach einem der vorherigen Ansprüche, wobei das erste Substrat (1) und/oder das zweite Substrat (1') ein Direct Copper Bonding oder ein Direct Aluminium Bonding Substrat ist.

12. Ein Verpackungsstapel, umfassend eine Vielzahl von aufeinandergestapelten Verpackungseinheiten (10) nach einem der vorherigen Ansprüche.

13. Ein Verfahren zur Verpackung von Substraten (1, 1'), umfassend die folgenden Schritte:
- Bereitstellen eines ersten Substrats (1),
- Auflegen eines Abstandshalters (4) auf das erste Substrat (1), und
- Auflegen eines zweiten Substrats (1') auf den Abstandshalter (4),
wobei jeweils auf eine Oberfläche des ersten Substrats (1) und auf eine Oberfläche des zweiten Substrats (1') ein Metalldepot (2, 2') aufgebracht ist und auf den beiden Metalldepots (2, 2') je ein Klebepunkt (3, 3') angeordnet ist,
wobei der Abstandshalter (4) so auf das erste Substrat (1) aufgelegt ist, dass der Abstandshalter (4) das erste Substrat (1) nur außerhalb des Klebepunkts (3) berührt, wobei der Abstandshalter (4) stegförmig ist, und
wobei zumindest das erste Substrat (1) eine Vielzahl von nebeneinander angeordneten Einzelsubstraten umfasst und der Abstandshalter (4) die Einzelsubstrate umrandet.

## Claims

1. A packaging unit (10) for substrates (1, 1'), comprising:
- a first substrate (1),
- a spacer (4), and
- a second substrate (1'),
wherein the spacer (4) is placed onto the first substrate (1) and the second substrate (1') is placed onto the spacer (4),
wherein a metal depot (2, 2') is disposed onto a surface of the first substrate (1) as well as onto a surface of the second substrate (1') and an adhesion point (3, 3') is disposed on both metal depots (2, 2'), and
wherein the spacer (4) is placed onto the first substrate (1) such that the spacer (4) touches the first substrate (1) only outside the adhesion point (3),
wherein the spacer (4) is strut-shaped, and
wherein at least the first substrate (1) comprises a plurality of individual substrates disposed adjacently and the spacer (4) borders the individual substrates.

2. Packaging unit (10) according to claim 1, wherein the first substrate (1) is a first metal-ceramic substrate and the second substrate (1') is a second metal-ceramic substrate.

3. Packaging unit (10) according to the preceding claim, wherein the first and the second metal-ceramic substrates (1, 1') each comprise a ceramic layer (11, 11') and at least one metallization layer (12, 12'), and the metallization layer (12, 12') comprises the surface onto which the metal depot (2, 2') is disposed.

4. Packaging unit (10) according to one of the preceding claims, wherein the metal depot (2, 2') comprises a solderable or sinterable metal or a solderable or sinterable alloy.

5. Packaging unit (10) according to one of the preceding claims, wherein the spacer (4) has a thickness between 200 and 1000 µm and preferably has a thickness between 300 and 800 µm.

6. Packaging unit (10) according to one of the preceding claims, wherein the spacer (4) is made of plastic or cardboard.

7. Packaging unit (10) according to one of the preceding claims, further comprising a further spacer (4') disposed onto the second substrate (1').

8. Packaging unit (10) according to the preceding claim, wherein the spacers (4) are of identical construction.

9. Packaging unit (10) according to one of the preceding claims, wherein the adhesion points (3, 3') are smearable at room temperature.

10. Packaging unit (10) according to one of the preceding claims, wherein the adhesion points (3, 3') are designed to secure an electronic component on the first substrate (1) and on the second substrate (1'), respectively.

11. Packaging unit (10) according to one of the preceding claims, wherein the first substrate (1) and/or the second substrate (1') is a direct copper bonding or a direct aluminum bonding substrate.

12. A packaging stack comprising a plurality of packaging units (10) stacked onto one another according to any of the preceding claims.

13. A method of packaging substrates (1, 1') comprising the following steps:
- providing a first substrate (1),
- placing a spacer (4) onto the first substrate (1), and
- placing a second substrate (1') onto the spacer (4),
wherein a metal depot (2, 2') is disposed onto a surface of the first substrate (1) as well as onto a surface of the second substrate (1') and an adhesion point (3, 3') is disposed on both metal depots (2, 2'), and
wherein the spacer (4) is placed onto the first substrate (1) such that the spacer (4) touches the first substrate (1) only outside the adhesion point (3),
wherein the spacer (4) is strut-shaped, and
wherein at least the first substrate (1) comprises a plurality of individual substrates disposed adjacently and the spacer (4) borders the individual substrates.

## Revendications

1. Unité d'emballage (10) pour substrats (1, 1'), comprenant :
- un premier substrat (1),
- un espaceur (4) et
- un deuxième substrat (1'),
dans laquelle l'espaceur (4) est disposé sur le premier substrat (1) et le deuxième substrat (1') est disposé sur l'espaceur (4),
dans laquelle un dépôt métallique (2, 2') est appliqué respectivement sur une surface du premier substrat (1) et sur une surface du deuxième substrat (1'), et un point de colle (3, 3') est agencé sur chacun des deux dépôts métalliques (2, 2'), et
dans laquelle l'espaceur (4) est disposé sur le premier substrat (1) de telle sorte que l'espaceur (4) ne soit en contact avec le premier substrat (1) qu'à l'extérieur du point de colle (3),
dans laquelle l'espaceur (4) est en forme de traverse, et
dans laquelle au moins le premier substrat (1) comprend une pluralité de substrats individuels agencés les uns à côté des autres et l'espaceur (4) borde les substrats individuels.

2. Unité d'emballage (10) selon la revendication 1, dans laquelle le premier substrat (1) est un premier substrat métallo-céramique et le deuxième substrat (1') est un deuxième substrat métallo-céramique.

3. Unité d'emballage (10) selon la revendication précédente, dans laquelle le premier et le deuxième substrat métallo-céramique (1, 1') comprennent chacun une couche céramique (11, 11') et au moins une couche de métallisation (12, 12'), et la couche de métallisation (12, 12') présente la surface sur laquelle le dépôt métallique (2, 2') est appliqué.

4. Unité d'emballage (10) selon l'une quelconque des revendications précédentes, dans laquelle le dépôt métallique (2, 2') comprend un métal brasable ou frittable ou un alliage brasable ou frittable.

5. Unité d'emballage (10) selon l'une quelconque des revendications précédentes, dans laquelle l'espaceur (4) présente une épaisseur comprise entre 200 et 1000 µm, et présente de préférence une épaisseur comprise entre 300 et 800 µm.

6. Unité d'emballage (10) selon l'une quelconque des revendications précédentes, dans laquelle l'espaceur (4) est fabriqué en matière plastique ou en carton.

7. Unité d'emballage (10) selon l'une quelconque des revendications précédentes, comprenant en outre un espaceur supplémentaire (4'), qui est disposé sur le deuxième substrat (1').

8. Unité d'emballage (10) selon la revendication précédente, dans laquelle les espaceurs (4) sont de construction identique.

9. Unité d'emballage (10) selon l'une quelconque des revendications précédentes, dans laquelle les points de colle (3, 3') sont étalables à température ambiante.

10. Unité d'emballage (10) selon l'une quelconque des revendications précédentes, dans laquelle les points de colle (3, 3') sont configurés de manière à fixer respectivement un composant électronique sur le premier substrat (1) et sur le deuxième substrat (1').

11. Unité d'emballage (10) selon l'une quelconque des revendications précédentes, dans laquelle le premier substrat (1) et/ou le deuxième substrat (1') est un substrat Direct Copper Bonding ou Direct Aluminium Bonding.

12. Empilement d'emballage, comprenant une pluralité d'unités d'emballage (10) selon l'une quelconque des revendications précédentes empilées les unes sur les autres.

13. Procédé d'emballage de substrats (1, 1'), comprenant les étapes suivantes :
- la préparation d'un premier substrat (1),
- la disposition d'un espaceur (4) sur le premier substrat (1), et
- la disposition d'un deuxième substrat (1') sur l'espaceur (4),
dans lequel un dépôt métallique (2, 2') est appliqué respectivement sur une surface du premier substrat (1) et sur une surface du deuxième substrat (1'), et un point de colle (3, 3') est agencé sur chacun des deux dépôts métalliques (2, 2'),
dans lequel l'espaceur (4) est disposé sur le premier substrat (1) de telle sorte que l'espaceur (4) ne soit en contact avec le premier substrat (1) qu'à l'extérieur du point de colle (3),
dans lequel l'espaceur (4) est en forme de traverse, et
dans lequel au moins le premier substrat (1) comprend une pluralité de substrats individuels agencés les uns à côté des autres et l'espaceur (4) borde les substrats individuels.
